# EUROPEAN PATENT SPECIFICATION

(11) **EP 2 848 959 B1**
(45) Date of publication and mention of the grant of the patent: **01.04.2020**
(21) Application number: 14182561.2
(22) Date of filing: 28.08.2014
(51) Int. Cl.: G01S 7/35, G01S 7/40, G01S 13/93, G01S 13/34, H03C 3/08

(54) **System to linearize a frequency sweep versus time**
System zur Linearisierung einer Frequenzabtastungszeit
Système pour linéariser un balayage de fréquence par rapport au temps

(30) Priority: 12.09.2013 US 201314024940
(43) Date of publication of application: 18.03.2015
(73) Proprietor: Aptiv Technologies Limited, St. Michael (BB)
(72) Inventor: Searcy, James F., Westfield, IN 46074 (US); Rossiter, Ryan K., Kokomo, IN 46902 (US)
(74) Representative: Manitz Finsterwald Patent- und Rechtsanwaltspartnerschaft mbB

(56) References cited:
- US-A- 4 593 287
- US-A- 4 754 277
- US-A- 5 694 132
- US-A1- 2010 245 160

## Description

### TECHNICAL FIELD OF INVENTION

This disclosure generally relates to a system for generating a variable frequency, and more particularly relates to a using an integrator to vary the control signal provided to a voltage controlled oscillator (VCO) so the frequency value changes linearly over time.

### BACKGROUND OF INVENTION

It is known to use a voltage controlled operator (VCO) to generate a signal that includes a series of frequency ramps. Such a signal is sometimes called a 'fast chirp' waveform and is used in a radar system marketed by Delphi Inc. of Troy, MI as a Simultaneous Transmit and Receive Pulse-Doppler (STAR-PD) radar system. This waveform consists of a series of frequency ramps that sweep frequency, for example, from seventy-seven Giga-Hertz (77GHz) to seventy-six Giga-Hertz (76GHz) in forty-six microseconds (46us), and repeats that sweep every fifty microseconds (50us). It is preferable that the frequency sweep for a radar system using a fast chirp type signal be highly linear (i.e. - constant slope versus time), for example, less than 0.5% non-linearity to optimize the performance of the radar system.

Typical automotive radar systems use a VCO that has a relatively non-linear voltage-to-frequency characteristic as such VCO's are relatively inexpensive. That is, a linear change in a control signal into the VCO will not result in a linear change in frequency. Two commonly-used approaches to generate a more linear frequency ramp or sweep are to use a phase-lock-loop (PLL), or to control the VCO open-loop with a control signal directly from a digital-to-analog converter (DAC). PLLs undesirably increase the cost of a radar system. Open loop control with a DAC will typically use some prior knowledge about the VCO non-linear characteristic curve to generate a non-linear control voltage designed to produce a linear frequency ramp. However, as the DAC outputs a stair-step waveform with discontinuities, the signal output by the VCO generally has unwanted spurs in the spectrum. A higher resolution DAC may be used to reduce the frequency spurs, but this undesirably increases the cost of the radar system. A filter can be used to smooth the control voltage signal, but this undesirably increases the minimum time between the end of one chirp and the beginning of the next chirp. US Patents 4593287, US 5694132 and US 4754277 describe a frequency sweep linearizer. US patent Application Publication 2010/0245160 describes a signal generation circuit. United States Patent No. 4,470,025 discloses a long-term drift correction technique for a chirped frequency-shift-keyed oscillator. United States Patent No. 4,940,982 discloses an analog-to-digital converter that is fast and accurate.
In view of the above problems it is an object of the invention to provide an improved system for generating a variable frequency. The object is satisfied by the subject-matter of claim 1.
A system for generating a variable frequency is provided. The system includes a voltage controlled oscillator (VCO) and an integrator. The VCO is configured to output a frequency signal with a frequency value dependent on a voltage value of a control signal. The integrator is configured to vary the control signal provided to the VCO. The ramp rate of the integrator is varied so the frequency value changes at a substantially constant frequency rate over a period of time.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a diagram of a system for generating a variable frequency in accordance with one embodiment;
Fig. 2 is a graph of a signal output by the system of Fig. 1 in accordance with one embodiment; and
Fig. 3 is a diagram of a system for generating a variable frequency that is an alternative to the system of Fig. 1 in accordance with one embodiment.

### DETAILED DESCRIPTION

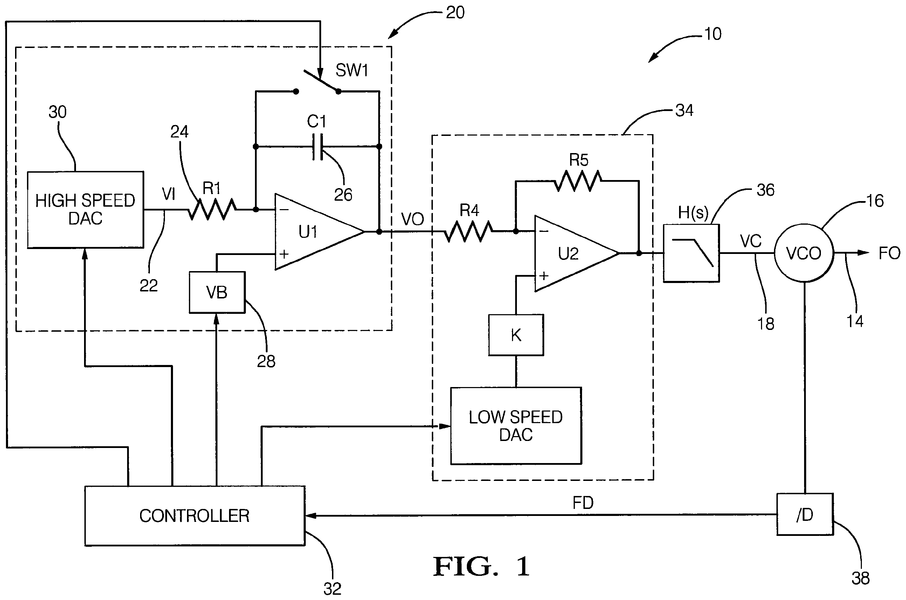

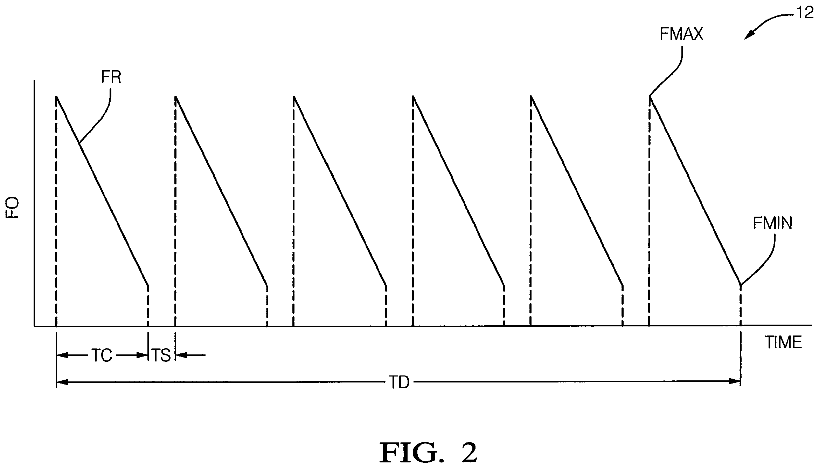

Fig. 1 illustrates a non-limiting example of a system 10 for generating a variable frequency signal FO such as a chirp signal 12 (Fig. 2). As will become apparent in the description that follows, the frequency signal FO advantageously exhibits a highly linear characteristic. That is, the change in frequency value 14 versus time has a substantially constant slope or frequency rate FR over a period of time TC.

The system 10 includes a voltage controlled oscillator (VCO), hereafter often referred to as the VCO 16. In general, the VCO 16 is configured to output a frequency signal FO with a frequency value 14 that is dependent on a voltage value 18 of a control signal VC. As minimizing the cost of the system 10 is desirable, especially for automotive radar sensors, using an inexpensive VCO is preferred. However, as inexpensive VCO's generally have a non-linear voltage-to-frequency conversion characteristic, but a constant frequency slope is desired for a radar sensor, an inexpensive way to generate the control signal VC is to have a voltage value 18 that varies over time in such a way as to compensate for the non-linear voltage-to-frequency conversion characteristic of the VCO.

Prior attempts of using a digital-to-analog converter (DAC) to directly generate the control signal VC had undesirable results as the stair-step nature of the signal output by the DAC caused spurious noise in the spectrum of the frequency value 14. Accordingly, a way to generate a control signal VC that is smoother (i.e. - with reduced discontinuities) is desired. To this end, the system 10 includes an integrator 20 configured to vary the control signal VC provided to the VCO. In general, the integrator 20 is configured so a ramp rate of the integrator 20 (i.e. the ramp rate of the output voltage VO) is varied so the frequency value 14 changes at a substantially constant frequency rate FR over a period of time TC (Fig. 2).

As will be recognized by those in the electronics arts, when the switch SW1 is closed, the output voltage VO is equal to the bias voltage VB. It should also be recognized that when the switch SW1 is open, the rate at which the output voltage VO changes is a function of the difference between input value 22 of the input voltage VI and the bias value 28 of the bias voltage VB, the resistance value 24 of the resistor Rl, and the capacitance value 26 of the capacitor C1. If the bias value 28, the resistance value 24 and the capacitance value 26 are constant, then the ramp rate of the integrator, that is the rate at which the output voltage VO changes, is based on or determined by the input value 22 of an input signal VI to the integrator.

In this non-limiting example the input value 22 is determined by a digital to analog convertor (DAC), hereafter the DAC 30. If the input value 22 of the input voltage VI is varied by varying the output of the DAC, then the ramp rate of the output voltage VO can be varied, and so the output voltage VO will have a piece-wise linear interpolation characteristic. Analysis has shown that using a control signal VC with such a piece-wise linear interpolation shape provides a frequency signal FO with fewer spurious frequency components when compared to using directly the stair-step type waveform output by a DAC as the control signal VC.

It is recognized that there are other ways to vary the ramp rate or integration rate of the integrator 20. For example, the resistance value 24 of the resistor R1, the capacitance value 26 of the capacitor C1, or the bias value 28 of the bias voltage VB could be varied independently or cooperatively, with or without varying the input value 22 of the input voltage VI. The choice of varying the ramp rate of the integrator 20 by varying the input value 22 of the input voltage VI was selected based on convenience. The bias voltage VB may be a voltage divider network connected to a reference voltage such as a supply voltage for the various electronics so that the bias value 28 is fixed, or a second DAC so that the bias value 28 is adjustable.

Continuing to refer to Fig. 1, the system 10 may include a controller 32 configured to control the DAC 30, and other aspects of the system 10 as will be further described below. The controller 32 may include a processor (not shown) such as a microprocessor or other control circuitry such as analog and/or digital control circuitry including an application specific integrated circuit (ASIC) for processing data as should be evident to those in the art. The controller 32 may include memory, including nonvolatile memory, such as electrically erasable programmable read-only memory (EEPROM) for storing one or more routines, thresholds and captured data. The one or more routines may be executed by the processor to perform steps for controlling signals output by the controller 32 for linearizing the output of the VCO 16 as described herein.

The non-linear characteristics of the VCO 16 may be pre-programmed into the controller 32 and used to control the input value 22 of the input voltage VI output by the DAC in order to generate a linearized frequency signal FO. As used herein, linearized means that the slope indicated by the frequency rate FR is substantially constant, where substantially means that the linearity performance of the system 10 meets the linearity requirements of whatever the system is applied to, a radar sensor for example, which may require a linearity performance characteristic of less than 0.5%.

Alternatively, the controller 32 may be configured to detect or receive the frequency signal FO and determine the non-linearity characteristics of the VCO 16 by direct measurement. Such a configuration may be advantageous if the non-linearity characteristics of the VCO 16 change, for example, over time or over temperature. If the non-linearity characteristics do change over time or temperature, the controller can 'learn' those characteristics and thereby further refine control of the DAC 30 to better linearize the frequency signal FO. If the application does not need a highly linearized frequency sweep versus time performance characteristic, or a frequency signal FO with an amount of spurious frequency components in the spectrum of the frequency signal FO is acceptable, then the addition of the integrator may be unnecessary.

The system 10 may also include a gain-and-offset stage 34 to further adjust the value of the control signal VC based on the output voltage VO. The system may also include a filter 36 to further smooth the signal provided to the VCO 16. It should be recognized that the filter 36 is generally characterized as a low-pass-filter, and that such a filter would not need to be as aggressive as a filter that would be necessary if the output of the DAC 30 was applied directly to the VCO 16 without the smoothing effects of the integrator 20. In other words, without the integrator 20, the characteristics of the filter 36 would likely include a higher cut-off frequency, and/or a higher order than what would be sufficient for the filter 36 to smooth the piece-wise linear interpolation signal from the integrator 20.

The system may also include a frequency divider 38 configured to divide the frequency signal FO output by the VCO 16 to a divided frequency FD that is sampled by controller 32 to determine the frequency value 14. The controller 32 can thus determine the voltage-frequency characteristic curve of the VCO, in order to determine the desired control signal to be created by the Integrator 20.

Referring now to Fig. 2, for a radar sensor, suitable values for the period of time TC, the silent time TS and the time duration TD are 46us, 4us, and 300us, respectively. Suitable values for the frequency value 14 include a maximum frequency FMAX of 77GHz, and a minimum frequency value of 76GHz. These values are only example values as it is recognized that other values may be suitable for radar sensors, or for other electrical systems that need a signal with a linear frequency sweep.

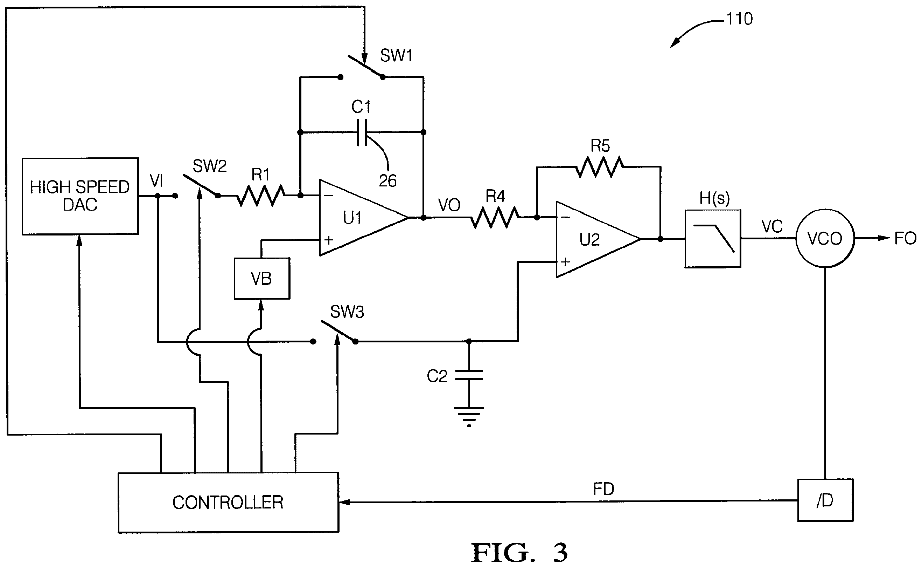

Fig. 3 illustrates an alternative to the system 10 shown in Fig. 1, hereafter referred to as the system 110. In this example, the Low speed DAC and gain block K are replaced with a sample and hold circuit formed by the switch SW3 and the capacitor C2. It is recognized that the bias voltage VB could also be replaced by a similar sample and hold circuit. Alternatively, the integrator 20 illustrated in Figs. 1 and 3 could be replaced with a sample and hold type circuit that applies a voltage to a capacitor, and then a variable current sink would draw current from that capacitor to generate the output voltage VO.

Accordingly, a system 10 and system for generating a linearized variable frequency from a voltage controlled oscillator (VCO) that can be characterized as non-linear is provided. The resolution of the DAC 30 is selected so that in cooperation with the integrator a control signal VC can be provided to the VCO 16 such that the frequency signal FO varies the frequency value 14 over time more linearly than would be the case if the DAC 30 was used without the smoothing effects of the integrator 20. Alternatively, by adding the integrator 20 to the system 10, the performance/resolution requirements of the DAC may be relaxed and thereby reduce the cost of generating a signal such as the chirp signal illustrated in Fig. 2.

While this invention has been described in terms of the preferred embodiments thereof, it is not intended to be so limited, but rather only to the extent set forth in the claims that follow.

## Claims

1. A system (10) for generating a variable frequency, said system (10) comprising:
a voltage controlled oscillator, VCO, (16) configured to output a frequency signal with a frequency value (14) dependent on a voltage value (18) of a control signal; and
an integrator (20) configured to provide the control signal to the VCO (16), said system (10) being **characterized by** comprising :
a digital to analog converter, DCO, (30) that is configured to control an input voltage (22) of the integrator (20) so an output voltage, VO, of the integrator (20) has a piece-wise linear interpolation characteristic so the frequency value (14) changes at a substantially constant frequency rate over a period of time.

## Patentansprüche

1. System (10) zum Erzeugen einer variablen Frequenz, wobei das System (10) umfasst:
einen spannungsgesteuerten Oszillator VCO (16), der ausgestaltet ist, um ein Frequenzsignal mit einem Frequenzwert (14) auszugeben, der von einem Spannungswert (18) eines Steuerungssignals abhängt; und
einen Integrierer (20), der ausgestaltet ist, um das Steuerungssignal für den VCO (16) bereitzustellen, wobei das System (10) **dadurch gekennzeichnet ist, dass** es umfasst:
einen Digital-Analog-Wandler DCO (30), der ausgestaltet ist, um eine Eingangsspannung (22) des Integrierers (20) so zu steuern, dass eine Ausgangsspannung VO des Integrierers (20) eine Kennlinie mit stückweise linearer Interpolation aufweist, sodass sich der Frequenzwert (14) mit einer im wesentlichen konstanten Frequenzrate über eine Zeitspanne hinweg verändert.

## Revendications

1. Système (10) pour générer une fréquence variable, ledit système (10) comprenant :
un oscillateur commandé en tension, VCO, (16) configuré pour délivrer un signal de fréquence ayant une valeur de fréquence (14) qui dépend d'une valeur de tension (18) d'un signal de commande ; et
un intégrateur (20) configuré pour fournir le signal de commande au VCO (16),
ledit système (10) étant **caractérisé en ce qu'**il comprend :
un convertisseur numérique-analogique, DCO, (30) qui est configuré pour commander une tension d'entrée (22) de l'intégrateur (20) de sorte qu'une tension de sortie, VO, de l'intégrateur (20) ait une caractéristique d'interpolation linéaire par morceaux, de sorte que la valeur de fréquence (14) change à un taux de fréquence sensiblement constant sur une période de temps.
